# EUROPEAN PATENT APPLICATION

(11) **EP 2 434 847 A1**
(43) Date of publication of application: **28.03.2012**
(21) Application number: 09252692.0
(22) Date of filing: 27.11.2009
(51) Int. Cl.: H05K 3/46

(54) **Circuit board**

(71) Applicant: BAE Systems PLC, London SW1Y 5AD (GB)
(72) Inventor: The designation of the inventor has not yet been filed
(74) Representative: BAE SYSTEMS plc Group IP Department

(57) **Abstract**

A multilayer circuit board, comprising: a plurality of printed circuit board layers arranged stacked together; and a conductively plated via; a surface of a through which the via passes comprises a conducting region surrounding a non-conducting region that is substantially centred around a point where the via intersects the surface; a smallest width dimension, e.g. diameter of the non-conducting region is greater than or equal to 4 times the diameter of the via; the via connects a conductive contact pad on one printed circuit board layer to a conductive contact pad on another printed circuit board layer, with the printed circuit board with the non-conducting region lying between the two connected layers; and the largest width dimension of the conductive contact pads on the surfaces of the printed circuit board layers connected by the via are less than the smallest width dimension of the non-conducting region.

## Description

### FIELD OF THE INVENTION

The present invention relates to circuit boards. In particular, the present invention relates to, but is not limited to, multilayer circuit boards for applications at frequencies equal to or greater than 1 GHz.

### BACKGROUND

Various radio frequency/microwave applications make use of multilayer printed circuit boards (PCBs). The use of multilayer PCBs involves the use of buried layers with e.g. transmission lines, contact pads, vias, and the like.

A variety of known processes are used in the manufacture of multilayer PCBs, for example electroplating, etching, bonding, and drilling, including back-drilling.

The close proximity of the layers, vias, contact pads, and the like leads to manufacturing complexity and restraints, and performance limitations.

### SUMMARY OF THE INVENTION

In a first aspect, the present invention provides a multilayer circuit board for applications at frequencies equal to or greater than 1 GHz, comprising: a plurality of printed circuit board layers arranged stacked together; and a conductively plated via passing through at least one of the printed circuit board layers;wherein a surface of a one of the printed circuit board layers through which the via passes comprises a conducting region surrounding a non-conducting region; the non-conducting region is substantially centred around a point on the surface where the via intersects the surface; a smallest width dimension, that includes the point on the surface, of the non-conducting region is greater than or equal to 4 times the diameter of the via; the via electrically connects a conductive contact pad on a surface of one printed circuit board layer to a further conductive contact pad on a surface of another printed circuit board layer, with the printed circuit board with the non-conducting region lying between the two printed circuit board layers with pads connected by the via; and the largest width dimension of the conductive contact pads on the surfaces of the printed circuit board layers connected by the via are less than the smallest width dimension of the non-conducting region.

A width of a conductive track connected to one of the conductive contact pads may be substantially larger than a largest width dimension of the conductive contact pads.

The smallest width dimension may be greater than or equal to 6 times the diameter of the via.

The smallest width dimension may be greater than or equal to 8 times the diameter of the via.

The non-conducting region may be substantially circular, and the smallest width dimension is the diameter of the non-conducting region.

The largest width dimension of the conductive contact pads may be their diameters.

The conductive track may be spaced from one or more conductive transmission lines on that surface, and the conductive track may be substantially parallel to the one or more conductive transmission lines.

The multilayer circuit board may further comprise a plurality of further conductively plated vias passing through the printed circuit board layers.

The further conductively plated vias may be arranged in more than one parallel rows of vias.

In a further aspect, the present invention provides a method of manufacturing a multilayer circuit board for applications at frequencies equal to or greater than 1GHz, the method comprising: providing a plurality of printed circuit board layers; providing, on the surface of one of the printed circuit board layers, a conducting region surrounding a non-conducting region; stacking together the plurality of printed circuit board layers; and forming a conductively plated via passing through at least the printed circuit board layer with the non-conducting region, the via being formed such that the non-conducting region is substantially centred around a point on the surface of the printed circuit board layer where the via intersects the surface; wherein the non-conducting region is provided such that a smallest width dimension, that includes the point on the surface, of the non-conducting region is greater than or equal to 4 times the diameter of the via; the via electrically connects a conductive contact pad on a surface of one printed circuit board layer to a further conductive contact pad on a surface of another printed circuit board layer, with the printed circuit board with the non-conducting region lying between the two printed circuit board layers with pads connected by the via; and the largest width dimension of the conductive contact pads on the surfaces of the printed circuit board layers connected by the via are less than the smallest width dimension of the non-conducting region.

### BRIEF DESCRIPTION OF THE DRAWINGS

Figure 1 is a process flowchart showing certain process steps carried out in an embodiment of a fabrication process for fabricating a multilayer circuit board;
Figure 2 is schematic illustration of a layer of unetched printed circuit board;
Figure 3 is a schematic illustration of a top view of the first layer;
Figure 4 is a schematic illustration of a top view of the second layer;
Figure 5 is a schematic illustration of a top view of the third layer;
Figure 6 is a schematic illustration of a top view of the fourth layer;
Figure 7 is a schematic illustration of an exploded view of the bonded layers and a primary via;
Figure 8 is a schematic illustration of an exploded view of the bonded layers secondary vias; and
Figure 9 is a schematic illustration of an exploded view of the bonded layers 11-15, a primary via and a back-drilled portion of the primary via.

### DETAILED DESCRIPTION

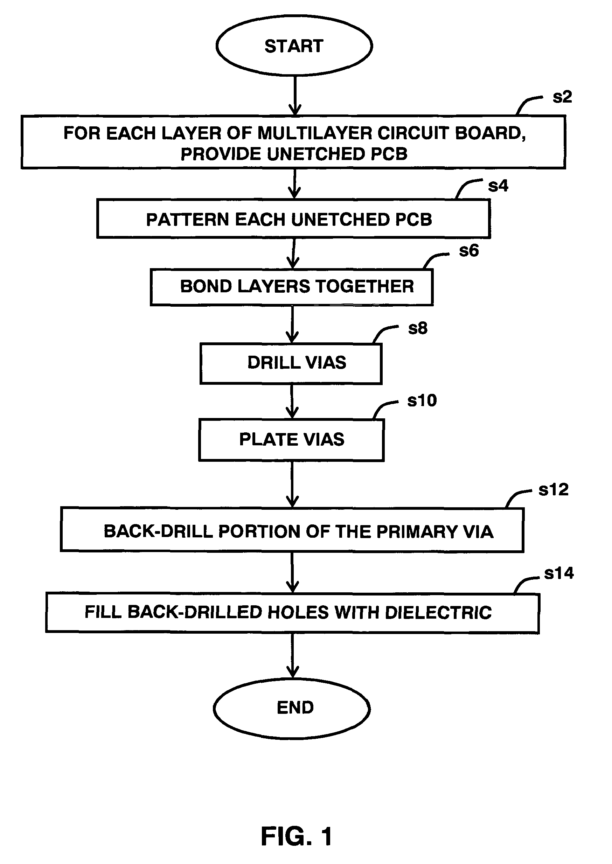

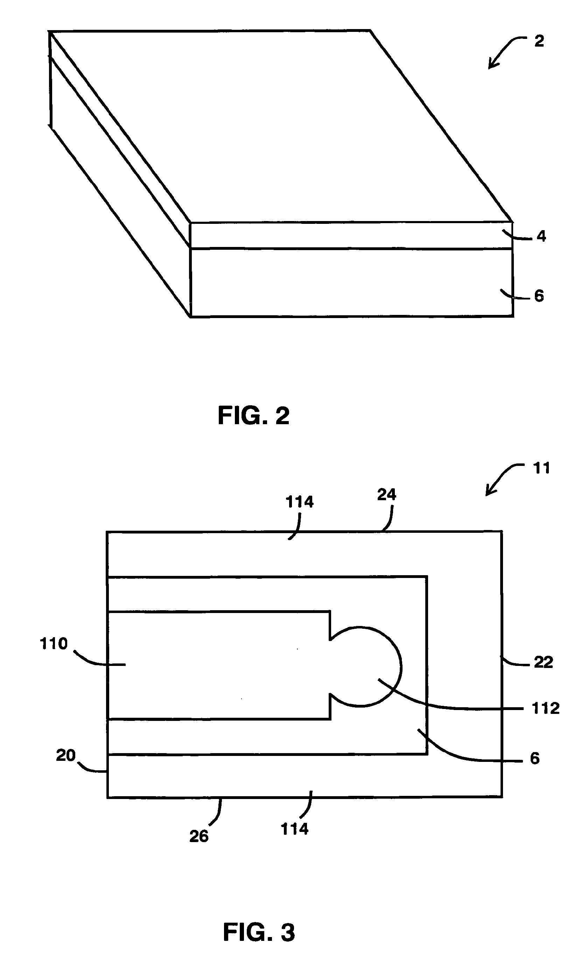

Figure 1 is a process flowchart showing certain process steps carried out in a fabrication process for fabricating a multilayer circuit board. The steps performed in the fabrication process are the same as those used in conventional fabrication methods for fabricating a multilayer circuit board, except where stated otherwise below. In particular, certain of the patterned, or etched, PCB layers from which the multilayer circuit board is formed are not conventional and are described in more detail later below with reference to Figures 3 to 6.

Terminology used in the description of the process that describes relative positions of features of the multilayer circuit board, such as "the top", "the bottom" etc. is used in a merely relative sense for ease of reference and is nonlimiting.

In this embodiment, the multilayer circuit board is a laminated structure comprising five PCB layers, hereinafter referred to as the first layer, the second layer, the third layer, the fourth layer, and the fifth layer, bonded together.

At step s2, five layers of unetched, or blank, PCB are provided.

Figure 2 is schematic illustration (not to scale) of a layer of unetched PCB 2. The unetched PCB 2 comprises a conductive layer 4, and a dielectric layer 6. The conductive layer 4 is deposited on a top surface of the dielectric layer 6.

In this embodiment, the conductive layer 4 and the dielectric layer 6 are bonded together using epoxy resin. The conductive layer 4 is made of copper. The dielectric layer 6 is made of polytetrafluoroethylene (PTFE).

At step s4, each of the five unetched PCBs 2 are patterned to form the first, second, third, fourth, and fifth layers of the multilayer circuit board respectively. The unetched PCBs 2 are patterned using a conventional process, for example a process of photoengraving using a photomask and chemical etching to remove unwanted copper from the dielectric layer 6. The respective structures of the first, second, third, fourth, and fifth layers of the multilayer circuit board are described in more detail later below with reference to Figures 3 to 6 respectively. The remaining steps s6-s14 of the fabrication process for fabricating a multilayer circuit board will described after the descriptions of Figures 3 to 6.

Figure 3 is a schematic illustration (not to scale) of a top view of the first layer. The first layer of the multilayer circuit board is hereinafter indicated by the reference numeral 11.

The top surface of the first layer 11 is substantially rectangular, having a front edge 20, a rear edge 22, a first side edge 24, and a second side edge 26. The front edge 20 is substantially parallel to the rear edge 24. The front edge 20 is on an opposite side of the rectangular top surface of the first layer 11 to the rear edge 24. The first side edge 24 is substantially parallel to the second side edge 26. The first side edge 24 is on an opposite side of the rectangular top surface of the first layer 11 to the second side edge 26. The front edge 20 and the rear edge 22 are each substantially perpendicular to each of the first side edge 24 and the second side edge 26.

In this embodiment, the first layer 11 comprises a first central track 110, a first contact pad 112 and transmission lines 114, each formed from the conductive layer 4.

The first central track 110 is a substantially rectangular strip of copper, i.e. the material of the conductive layer 4, joining a central portion of the front edge 20 to the first contact pad 112. The first central track 110 runs along a central axis of the top surface of the first layer 11, substantially parallel to, and substantially equidistant from, the first and second side edges 24, 26. In this embodiment, the first central track is 1.6mm wide.

The first contact pad 112 is a substantially circular portion of copper, i.e. the material of the conductive layer 4, attached to one end of the first central track 110. The first contact pad 112 is positioned on the top surface of the first surface 11 such that it is substantially equidistant from the first and second side edges 24, 26, and such that it is closer to the rear edge 22 than it is the front edge 20. In this embodiment, the first contact pad 112 is of diameter 1.3mm.

In this embodiment, the width of the first central track 110, i.e. the length of the edge of the central track 110 that joins the front edge 20 the top surface of the first layer 11, is wider than the diameter of the first contact pad 112 (as mentioned above, the central track 110 is 1.6mm wide, and the first contact pad 112 is of diameter 1.3mm).

The transmission lines 114 are formed from a strip of copper i.e. the material of the conductive layer 4, on the top surface of the first layer 11 that runs adjacent to the first side edge 24, the rear edge 22, and the second side edge 26. The transmission lines 114 are also adjacent to the outermost portions of the front edge 20, i.e. the portions of the front edge 20 that adjoin the first and second side edges 24, 26 respectively. The transmission lines 114 are separated from the first central track 110 and the first contact pad 112, i.e. the portion of the conductive layer 4 between the transmission lines 14 and the combination of the first central track 110 and the first contact pad 112 has been removed via etching.

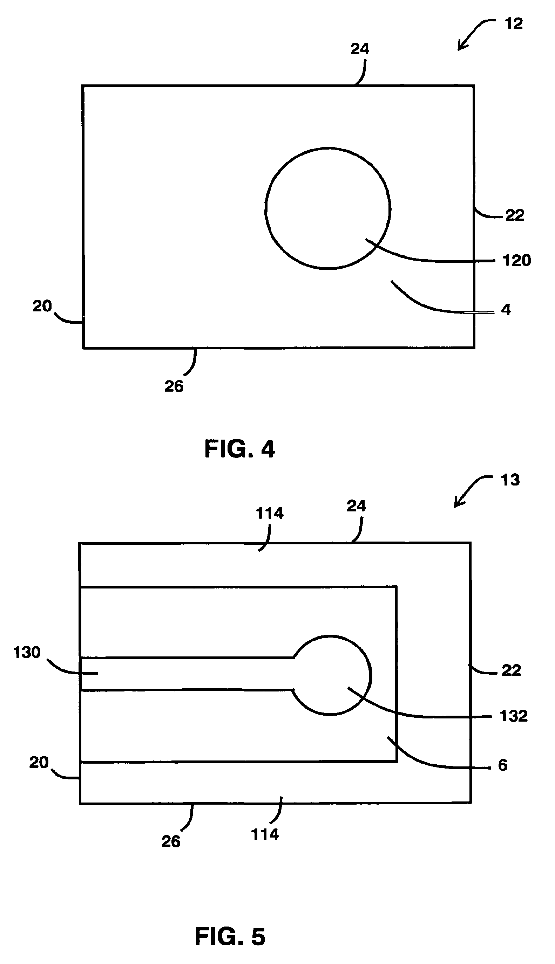

Figure 4 is a schematic illustration (not to scale) of a top view of the second layer. The second layer of the multilayer circuit board is hereinafter indicated by the reference numeral 12.

The second layer 12 is substantially the same size and shape as the first layer 11. However, the second layer 12 is patterned differently to the first layer 11. In Figure 4, the edges of the top surface of the second layer 12 are indicated by the same reference numerals as those used to indicate the corresponding edges of the top surface of the first layer 11 in Figure 3. Thus, the top surface of the second layer 12 is substantially rectangular, having a front edge 20, a rear edge 22, a first side edge 24, and a second side edge 26.

In this embodiment, the second layer 12 comprises a first clearance hole 120. The first clearance hole 120 is a substantially circular hole in the conductive layer 4 of the second layer 12. The first clearance hole 120 is formed by etching away a portion of the conductive layer 4 to reveal the dielectric layer 6 below. In this embodiment, the first clearance hole 120 is of diameter 2.38mm.

The first clearance hole 120 is positioned such that the when the first layer 11 is positioned on top of the second layer 12 such that the edges of the first layer 11 are aligned with the corresponding edges of the second layer 12, the centre of the first clearance hole 120 is positioned substantially directly below the centre of the first contact pad 112. Thus, the first clearance hole 120 is positioned on the top surface of the second surface 12 such that it is substantially equidistant from the first and second side edges 24, 26, and such that it is closer to the rear edge 22 than it is the front edge 20.

Figure 5 is a schematic illustration (not to scale) of a top view of the third layer. The third layer of the multilayer circuit board is hereinafter indicated by the reference numeral 13.

The third layer 13 is substantially the same size and shape as the first and second layers 11, 12. However, the third layer 13 is patterned differently to the first and second layers 11, 12. In Figure 5, the edges of the top surface of the third layer 13 are indicated by the same reference numerals as those used to indicate the corresponding edges of the top surfaces of the first and second layers 11, 12 in Figures 3 and 4 respectively. Thus, the top surface of the third layer 13 is substantially rectangular, having a front edge 20, a rear edge 22, a first side edge 24, and a second side edge 26.

In this embodiment, the third layer 11 comprises a second central track 130, and a second contact pad 132, each formed from the conductive layer 4.

The second central track 130 is a substantially rectangular strip of copper, i.e. the material of the conductive layer 4, joining a central portion of the front edge 20 of the third layer 13 to the second contact pad 132. The second central track 130 runs along a central axis of the top surface of the third layer 13, substantially parallel to, and substantially equidistant from, the first and second side edges 24, 26 of the third layer 13. In this embodiment, the second central track 130 is 0.47mm wide.

The second contact pad 132 is a substantially circular portion of copper, i.e. the material of the conductive layer 4, attached to one end of the second central track 130. In this embodiment, the second contact pad 132 is of diameter 0.8mm.

The second contact pad 132 is positioned such that the when the first layer 11 is positioned on top of the third layer 13 such that the edges of the first layer 11 are aligned with the corresponding edges of the third layer 13, the centre of the second contact pad 132 is positioned substantially directly below the centre of the first contact pad 112. Equivalently, the second contact pad 132 is positioned such that the when the second layer 12 is positioned on top of the third layer 13 such that the edges of the second layer 12 are aligned with the corresponding edges of the third layer 13, the centre of the second contact pad 132 is positioned substantially directly below the centre of the first clearance hole 120. Thus, the second contact pad 132 is positioned on the top surface of the third surface 11 such that it is substantially equidistant from the first and second side edges 24, 26 of the third layer 13, and such that it is closer to the rear edge 22 than it is the front edge 20 of the third layer 13.

In this embodiment, the width of the second central track 130, i.e. the length of the edge of the second central track 130 that joins the front edge 20 of the top surface of the third layer 13, is narrower than the diameter of the second contact pad 132 (as mentioned above, the width of the second central track 130 is 0.47mm and the diameter of the second contact pad 132 is 0.8mm). Thus, the width of the second central track 130 is narrower than the width of the first central track 110.

The fourth layer of the multilayer circuit board is substantially the same as the second layer 12, as described above with reference to Figure 4.

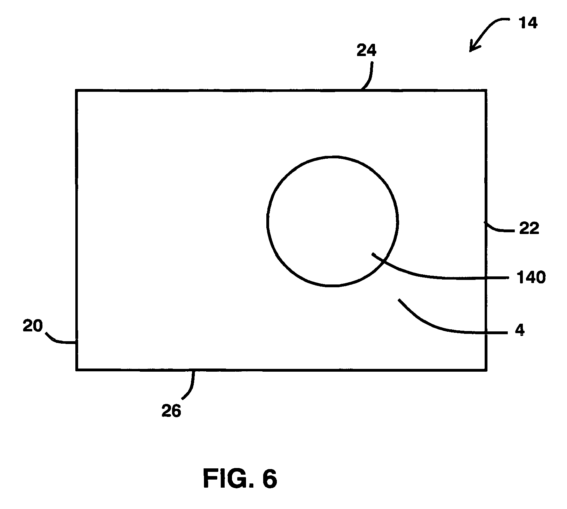

Figure 6 is a schematic illustration (not to scale) of a top view of the fourth layer. The fourth layer of the multilayer circuit board is hereinafter indicated by the reference numeral 14.

In Figure 6, the edges of the top surface of the fourth layer 14 are indicated by the same reference numerals as those used to indicate the corresponding edges of the top surfaces of the first, second, and third layers 11-13 in Figures 3-5 respectively. Thus, the top surface of the second layer 12 is substantially rectangular, having a front edge 20, a rear edge 22, a first side edge 24, and a second side edge 26.

The fourth layer 14 is patterned to be substantially the same as the second layer 12. In this embodiment, the fourth layer 14 comprises a second clearance hole 140 that is etched from the conductive layer 4 to reveal the dielectric layer 6 below.

The second clearance hole 140 is positioned such that the when the first layer 11 is positioned on top of the fourth layer 14 such that the edges of the first layer 11 are aligned with the corresponding edges of the fourth layer 14, the centre of the second clearance hole 140 is positioned substantially directly below the centre of the first contact pad 112. Equivalently, the second clearance hole 140 is positioned such that the when the second layer 12 is positioned on top of the fourth layer 14 such that the edges of the second layer 12 are aligned with the corresponding edges of the fourth layer 14, the centre of the second clearance hole 140 is positioned substantially directly below the centre of the first clearance hole 120. Equivalently, the second clearance hole 140 is positioned such that the when the third layer 13 is positioned on top of the fourth layer 14 such that the edges of the third layer 13 are aligned with the corresponding edges of the fourth layer 14, the centre of the second clearance hole 140 is positioned substantially directly below the centre of the second contact pad 132. Thus, the second clearance hole 140 is positioned on the top surface of the third surface 11 such that it is substantially equidistant from the first and second side edges 24, 26 of the third layer 13, and such that it is closer to the rear edge 22 than it is the front edge 20 of the third layer 13.

In this embodiment, the diameter of the first clearance hole 120 is 2.38mm and the diameter of the second clearance hole 140 is 2.04mm.

In this embodiment, the diameters of the first and second clearance holes 120, 140 are greater than the diameters of the first and second contact pads 112, 132.

In this embodiment, the fifth layer of the multilayer circuit board is unpatterned at step s4 of the fabrication process, i.e. the fifth layer of the multilayer circuit board is an unetched PCB 2, as described above with reference to Figure 2.

At step s6, the above described layers are bonded together in the following order: the first layer 11, the second layer 12, the third layer 13, the fourth layer 14, and the fifth layer.

A bottom surface of the first layer 11, i.e. a surface of the first layer 11 that is opposite the top surface of the first layer 11 shown in Figure 3, is bonded to the top surface of the second layer 12. A bottom surface of the second layer 12, i.e. a surface of the second layer 12 that is opposite the top surface of the second layer 12 shown in Figure 4, is bonded to the top surface of the third layer 13. A bottom surface of the third layer 13, i.e. a surface of the third layer 13 that is opposite the top surface of the third layer 13 shown in Figure 5, is bonded to the top surface of the fourth layer 14. A bottom surface of the fourth layer 14, i.e. a surface of the fourth layer 14 that is opposite the top surface of the fourth layer 14 shown in Figure 6, is bonded to the top surface of the fifth layer, i.e. the conductive layer 4 of the fifth layer.

In this embodiment, the layers are bonded together using epoxy resin.

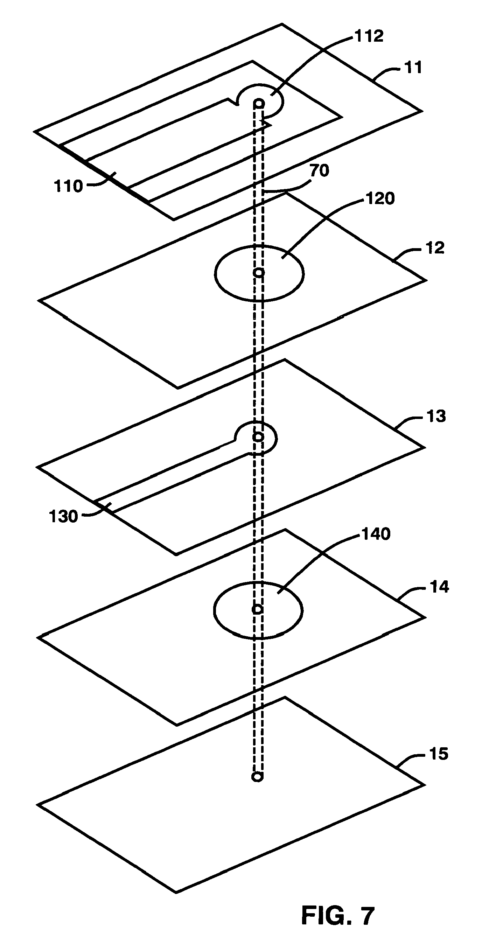

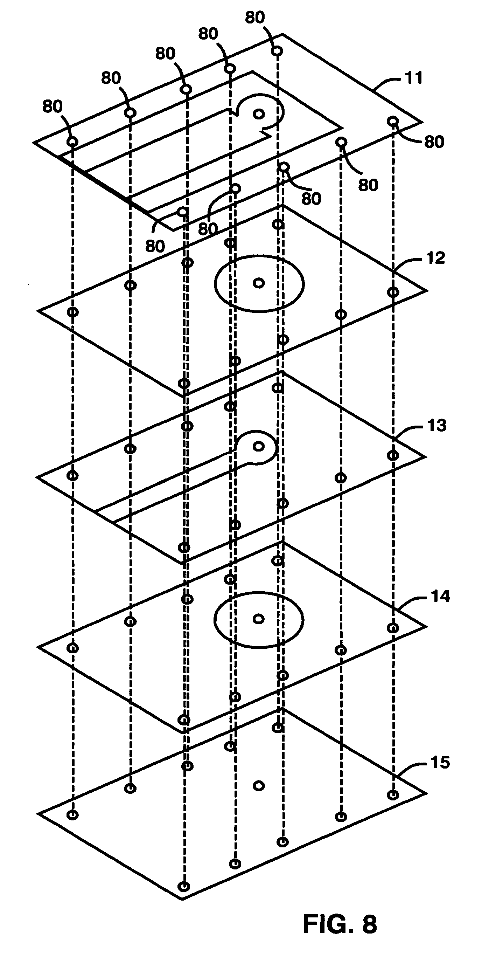

At step s8, a plurality of vias is drilled through the bonded layers. The vias that are drilled through the bonded layers at step s8 are described in more detail below with reference to Figures 7 and 8. The remaining steps s10-s14 of the fabrication process for fabricating a multilayer circuit board will described after the descriptions of Figures 7 and 8.

Figure 7 is a schematic illustration (not to scale) of an exploded view of the bonded layers i.e. the first layer 11, the second layer 12, the third layer 13, the fourth layer, and the fifth layer (which is indicated hereinafter by the reference numeral 15). For reasons of clarity, Figure 7 shows only the top surfaces of the layers 11-15. Figure 7 further shows a via, hereinafter referred to as the "primary via 70", that is formed through all of the bonded layers. The primary via 70 is indicated schematically in Figure 7 by dotted lines.

The primary via 70 is formed using a drilling process. In this embodiment, the primary via 70 is formed by drilling downwards through the following: the centre of the first contact pad 112 and the dielectric layer 6 of the first layer 11; the centre of the first clearance hole 120 and the dielectric layer 6 of the second layer 12; the centre of the second contact pad 132 and the dielectric layer 6 of the third layer 13; the centre of the second clearance hole 140 and the dielectric layer 6 of the fourth layer 14; and the conductive layer 4 and the dielectric layer 6 of the fifth layer 15. In this embodiment, the diameter of the primary via 70 is 0.4mm.

Figure 8 is a schematic illustration (not to scale) of an exploded view of the bonded layers 11-15. For reasons of clarity, Figure 8 shows only the top surfaces of the layers 11-15. Figure 8 further shows a plurality of further vias. Each further via of the plurality of further vias is indicated by a dotted line through each of the bonded layers 11-15. These further vias are hereinafter referred to as "secondary vias" and are each indicated by the reference numeral 80. The secondary vias 80 are arranged in two substantially parallel rows of vias. A first row of the secondary vias 80 comprises five vias, which are equally spaced on the portion of the transmission line 114 of the top surface of the first layer 11 that is contiguous with the first side edge 24. A second row of the secondary vias 80 comprises five vias, which are equally spaced on the portion of the transmission line 114 of the top surface of the first layer 11 that is contiguous with the second side edge 26.

The secondary vias 80 are each formed using a drilling process. In this embodiment, the secondary vias 80 are each formed by drilling downwards through the following: the transmission line 114 and the dielectric layer 6 of the first layer 11; the conductive layer 4 and the dielectric layer 6 of the second layer 12; the dielectric layer 6 of the third layer 13; the conductive layer 4 and the dielectric layer 6 of the fourth layer 14; and the conductive layer 4 and the dielectric layer 6 of the fifth layer 15. In this embodiment, the diameter of the secondary vias 80 is 0.5mm.

In operation the secondary vias 80 provide grounding and suppression of electromagnetic parallel plate modes.

In this embodiment, the primary via 70 and the secondary vias 80 are formed such that they are substantially parallel through the bonded layers 11-15.

In this embodiment, the width of the primary via 70 is such that the ratio of the diameter of the first clearance hole 120 (2.38mm) to the diameter of the primary via 70 (0.4mm) is 5.95:1, i.e. approximately 6:1. Generally (e.g. in other embodiments) the ratio of the diameter of the first clearance hole 120 to the diameter of the primary via 70 is greater than or equal to 4:1, preferably for example greater than or equal to 6:1, or for example greater than or equal to 8:1.

Also, in this embodiment the ratio of the diameter of the second clearance hole 140 (2.04mm) to the diameter of the primary via 70 (0.4mm) is 5.1:1, i.e. approximately 5:1. Generally (e.g. in other embodiments) the ratio of the diameter of the second clearance hole 140 to the diameter of the primary via 70 is greater than or equal to 4:1, preferably for example greater than or equal to 6:1, or for example greater than or equal to 8:1.

At step s10, the primary via 70 and the secondary vias 80 are plated to form conductive vias between the layers 11-15. This provides that current can flow between the layers or shielding can take place. In this embodiment, the primary via 70 and the secondary vias 80 are plated using copper.

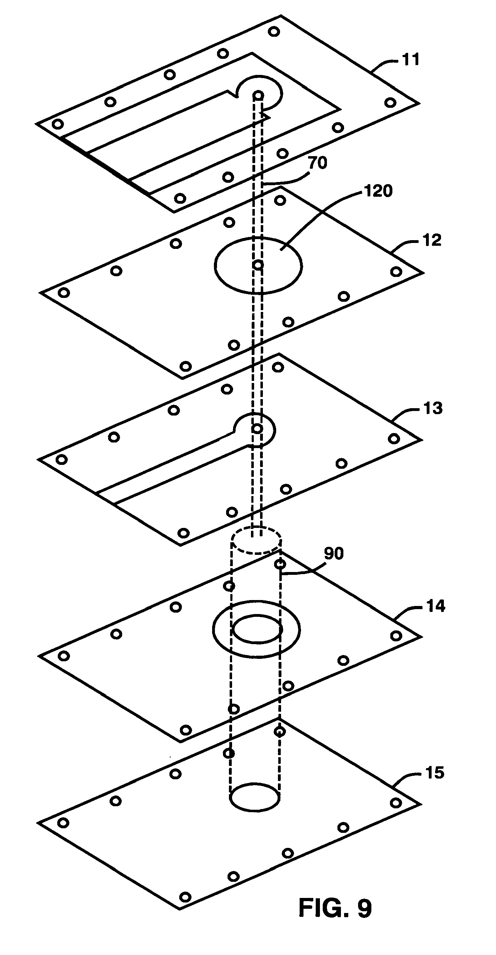

At step s12, a portion of the primary via 70 is back-drilled, as described below with reference to Figure 9.

Figure 9 is a schematic illustration (not to scale) of an exploded view of the bonded layers 11-15. For reasons of clarity, Figure 9 shows only the top surfaces of the layers 11-15. Figure 9 further shows the primary via 70 and a lower portion of the primary via and surrounding material that has been removed by a process of back-drilling, i.e. drilling away material from the bottom surface of the bonded layers 11-15. The portion of the primary via and surrounding material that has been removed by a process of back-drilling is hereinafter referred to as the "back-drilled hole 90".

In this embodiment, the back drilled hole 90 is formed along the path of the primary via 70, and is formed by drilling upwards through the following: the dielectric layer 6 and the conductive layer 4 of the fifth layer 15; the dielectric layer 6 and the centre of the second clearance hole of the fourth layer 14; and a portion of the dielectric layer 6 of the third layer 13. The back-drilled hole 90 does not pass through the top surface of the third layer 13.

The back-drilled hole 90 is substantially wider than that used to form the primary via 70. In this embodiment, the diameter of the back-drilled hole 90 is 1.0mm. Thus, in this embodiment, the ratio of the diameter of the back-drilled hole 90 (1.0mm) to the diameter of the primary via 70 (0.4mm) is 2.5. Such a ratio (or for example, any ratio greater than or equal to 2:1) advantageously tends to ensure that the back drilled hole 90 is formed such that all of the copper plating of the primary via 70 through which the back-drilled hole 90 is formed, is removed cleanly. The diameter of the back-drilled hole 90 is further selected to attempt to provide that although it is larger than the diameter of the primary via 70, nevertheless it is small enough to avoid or minimise radio frequency being radiated from it.

Furthermore, in this embodiment, the ratio of the diameter of the second clearance hole 140 (2.04mm) to the diameter of the back-drilled hole 90 (1.0mm) is 2.04:1, i.e. approximately 2:1. Generally (e.g. in other embodiments) the ratio of the diameter of the second clearance hole 140 to the diameter of the back-drilled hole 90 is greater than or equal to 1.5:1, preferably for example greater than or equal to 2:1 or for example greater than or equal to 3:1. Such ratios advantageously provide that the process of back-drilling the portion of the primary via 70 carried out at step s12 of the fabrication process for fabricating a multilayer circuit board, as described above with reference to Figures 1 and 9, tends to be easier to perform for at least the following reason. The relatively large diameter of the second clearance hole 140 enables the back-drilled hole 90 to be wider than the primary via 70 without the process of back-drilling the back-drilled hole 90 removing or otherwise displacing any of the conductive layer 4 of the fourth layer 14, for example in particular in a manner that might lead to short-circuits or other errors. This also allows a wider back-drilled hole 90 than might otherwise be the case, which therefore tends to provide greater leeway when ensuring that all of the copper plating of the primary via 70 through which the back-drilled hole 90 is formed, is removed. These advantages are provided to at least some extent provided that the diameter of the second clearance hole 140 is greater than the diameter of the back-drilled hole 90. However, these advantages are then further enhanced by the second clearance hole diameter being greater than the diameter of the back-drilled hole 90 to the extent of the various ratios mentioned above.

At step s14, the back-drilled hole 90 is filled with dielectric material. Preferably the dielectric material is the same, or similar, material as the main dielectric material of the printed circuit boards.

The device that results from performing steps s2 to s14 of the fabrication process is the multilayer circuit board. Thus, a fabrication process for fabricating a multilayer circuit board is provided.

During an example operation of the multilayer circuit board fabricated using the above described method, current flows along the second central track 130 from the front edge 20 of the third layer 13 to the second contact pad 132, along the plated primary via 70 through the second layer 12 to the first contact pad 112 of the first layer, and along the first central track 110 from the first contact pad 112 to the front edge 20 of the first layer 11.

An advantage provided by the first clearance hole 120 having a larger diameter than the first contact pad 112 (due in part to the ratio between the diameter of the first clearance hole 120 and the primary via 70 being approximately 6:1) is that, during use, the capacitance between the first layer 11 and the second layer 12 tends to be reduced. This is because, as a result of the wider first clearance hole 120, the conductive surfaces 4 of the first and second layers 11, 12 tend to be further apart than in conventional multilayer circuit boards. Thus, the performance of the provided multilayer circuit board tends to be improved. Also, the first clearance hole 120 has a larger diameter than the second contact pad 132. Thus, the capacitance between the second layer 12 and the third layer 13 tends to be reduced. This is because, as a result of the wider first clearance hole 120, the conductive surfaces 4 of the second and third layers 12, 13 tend to be further apart than in conventional multilayer circuit boards. Thus, the performance of the provided multilayer circuit board tends to be improved.

An advantage provided by the second clearance hole 140 having a larger diameter than the second contact pad 132 is that, during use, the capacitance between the third layer 13 and the fourth layer 14 tends to be reduced. This is because, as a result of the wider second clearance hole 140, the conductive surfaces 4 of the third and fourth layers 13, 14 tend to be further apart than in conventional multilayer circuit boards. Thus, the performance of the provided multilayer circuit board tends to be improved.

An advantage provided by filling the back-drilled hole 90 with dielectric material, as described above at step s14 is that, during use of the multi-layer circuit board, the risk of shorting to lower layers tends to be reduced. For example, air and/or water in an unfilled back-drilled hole may enable current to flow from the second contact pad 132 to the fourth or fifth layers 14, 15.

An advantage provided by the first central track 110 being of relatively large width (i.e. the first central track 110 being of width larger than that of the second central track 130) is that a 50 Ohm impedance, which is required for microwave transmissions, can be maintained in the multilayer circuit board whilst enabling the first contact pad 112 to be of smaller diameter than would be enabled if using a relatively narrower central track, as is used in a conventional multilayer circuit board. The first contact pad 112 having a relatively small diameter advantageously tends to provide that the capacitance in the multilayer circuit board is reduced. In other words, by virtue of the first contact pad 112 having a relatively small diameter, excess capacitance is reduced. Thus, the performance of the provided multilayer circuit board tends to be improved.

An advantage provided by the secondary vias 80 formed at steps s8 and s10 of the above method, as described above with reference to Figures 1 and 8 is that, during use, grounding and suppression of electromagnetic parallel plate modes tends to be provided. Moreover, the drilling and inspection of the secondary vias 80 tends to be easier than for a different configuration of vias, for example a horse-shoe shaped arrangement of vias. Also, analysis of the multilayer circuit board tends to be easier than analysis of a circuit board with a different arrangement of vias.

A further advantage provided by the secondary vias 80 is that the secondary vias allow for different orientations of incoming/outgoing tracks without the need to reposition the secondary vias 80. In the above embodiment the second central track 130 is the incoming track because, during use, current enters the multilayer circuit board along this track, and the first central track 110 is the outgoing track because, during use, current exits the multilayer circuit board along this track. Thus, current enters and exits the multilayer circuit board via the front edge 20. However, in other embodiments, current may enter and/or exit the multilayer circuit board without the need to rearrange, i.e. change the positions of, the secondary vias 80. For example, current may enter the multilayer circuit board via the front edge 20 and exit via the rear edge 22, or current may enter the multilayer circuit board via the rear edge 22 and exit via the front edge 20, or current may enter the multilayer circuit board via the rear edge 22 and exit via the rear edge 22. In embodiments in which current enters the multilayer circuit board via the front edge 20 the third layer 13 may be configured such that the second central track 130 joins a central portion of the rear edge 22 of the third layer 13 to the second contact pad 132 and runs along a central axis of the top surface of the third layer 13, substantially parallel to, and substantially equidistant from, the first and second side edges 24, 26 of the third layer 13. In embodiments in which current exits the multilayer circuit board via the rear edge 22, the first layer 11 may be configured such that the first central track 110 joins a central portion of the rear edge 22 to the first contact pad 112 and runs along a central axis of the top surface of the first layer 11, substantially parallel to, and substantially equidistant from, the first and second side edges 24, 26. Also, the transmission lines 114 may run adjacent to the first side edge 24, the front edge 20, and the second side edge 26.

A further advantage provided by the parallel layout of the secondary vias 80 is that they tend to be effective at preventing radio frequency radiation from the second clearance hole 140 being propagated into the lower dielectric layer (significantly more so than is the case with e.g. a conventional horseshoe layout).

An advantage provided by the transmission lines 114 formed on the top surface of the first layer 11, and separate from the first central track 110 and first contact pad 132, is that microstrip transmission tends to be reduced. This is because the transmissions lines 114 provide for coplanar microwave transmission which, during use, tends to confine the electric field close to the top surface of the first layer and reduce radiation into the surrounding atmosphere. Thus, the performance of the provided multilayer circuit board tends to be improved.

In the above embodiments, the unetched PCB comprises a conductive layer, and a dielectric layer. Also, the conductive layer is deposited on a top surface of the dielectric layer. However, in other embodiments the unetched PCB may comprises any number of appropriate layers, configured in any appropriate manner. For example, in other embodiments the unetched PCB comprises a dielectric layer, a conductive layer deposited on a top surface of the dielectric layer, and a further conductive layer deposited on a bottom surface of the dielectric layer.

In the above embodiments, the conductive layer is made of copper. However, in other embodiments the conductive layer is made of a different appropriate material.

In the above embodiments, the dielectric layer is made of polytetrafluoroethylene (PTFE). However, in other embodiments the dielectric layer is made of a different appropriate material.

In the above embodiments, at step s4 the unetched PCBs are patterned using a conventional process, for example a process of photoengraving using a photomask and chemical etching. However, in other embodiments the unetched PCBs are patterned using any a different appropriate process or combination of processes.

In the above embodiments, during the fabrication process certain layers are bonded together using epoxy resin. However, in other embodiments the layers are bonded together using a different appropriate process.

In the above embodiments, at steps s8-s10 vias are formed through the first, second, third, fourth, and fifth layers. However, in other embodiments any number of the vias is formed through any subset of the first, second, third, fourth, and fifth layers.

In the above embodiments, the secondary vias are arranged as two parallel rows of five substantially secondary vias along a first and second side edge of the multilayer layer circuit board. However, in other embodiments the set of secondary vias comprises any number of vias that may be configured in an appropriate manner. For example, in other embodiments the secondary vias are configured in a horse-shoe shape surrounding the first contact pad. In other embodiments, some or all of the vias are not parallel.

In the above embodiments, the vias are formed by a drilling process after the layers of the multilayer circuit board have been bonded together. However, in other embodiments any number of the vias is formed by any different appropriate process. Also, in other embodiments any number of the vias is formed before some or all of the layers are bonded together.

In the above embodiments, the width of the first central track is wider than the diameter of the first contact pad. However, in other embodiments the width of the first central track is less than or equal to the diameter of the first contact pad.

In the above embodiments, the width of the second central track is narrower than the diameter of the second contact pad. However, in other embodiments the width of the second central track is greater than or equal to the diameter of the second contact pad.

In the above embodiments, the width of the second central track is narrower than the width of the first central track. However, in other embodiments the width of the second central track is greater than or equal to the width of the first central track.

In the above embodiments, at step s14 the back-drilled hole is filled with dielectric material. However, in other embodiments the back-drilled hole is filled with different appropriate material. Also, in other embodiments, the back-drilled hole is not filled.

In the above embodiments, the multilayer circuit board comprises the first, second, third, fourth, and fifth layers which are patterned as described above at step s4, with reference to Figures 3 - 6. However, in other embodiments a multilayer circuit board having the same functionality as described above is fabricated using a different number of layers. In other embodiments, the layers are implemented in a different appropriate order so as to provide the above described functionality. Also, in other embodiments, some or all of the layers are patterned in the same or a different way to those layers described above so as to provide the above described functionality.

In the above embodiments, the multilayer circuit board is fabricated using steps s2-s14 of the fabrication process for fabricating a multilayer circuit board, as described above with reference to Figure 1. However, in other embodiments any of steps s2-s14 are carried out in a different appropriate order. In other embodiments, any of steps s2-s14 are carried out simultaneously. Also, in other embodiments, a multilayer circuit board having the above described functionality is fabricated using a different appropriate process having some of the same or different method steps.

In the above embodiments, the clearance holes 120, 140 (i.e. non-conducting regions) are circular shaped and hence their relevant dimension in the above description is their diameter. However, these clearance holes (non-conducting regions) need not be circular shaped, and when they are shaped other than circular, then their relevant dimension for comparison with and forming ratios with the other dimensions described, is their smallest width dimension that includes the point on the surface of the circuit board where the relevant primary via 70 (or an extension of the direction of the primary via 70) intersects the surface where the clearance hole is located.

The above embodiments, including the various dimensions and ratios described, are selected for use with microwave/radio frequency applications up to 15GHz. However, more generally, other embodiments may be implemented for use within some or all of the range of, say, 1 to 100GHz. To accommodate frequencies higher than 15GHz, the example dimensions of the particular embodiments described above are typically scaled down accordingly.

Although all the various layers have been described in the above embodiments, it will be appreciated that just the details of the layers 11 and 12, or of the layers 11, 12 and 13, in themselves provide embodiments of the invention, that may be implemented in arrangements that do not necessarily include the details of the other layers as described above.

## Claims

1. A multilayer circuit board for applications at frequencies equal to or greater than 1 GHz, comprising:
a plurality of printed circuit board layers arranged stacked together; and
a conductively plated via passing through at least one of the printed circuit board layers; wherein
a surface of a one of the printed circuit board layers through which the via passes comprises a conducting region surrounding a non-conducting region;
the non-conducting region is substantially centred around a point on the surface where the via intersects the surface;
a smallest width dimension, that includes the point on the surface, of the non-conducting region is greater than or equal to 4 times the diameter of the via;
the via electrically connects a conductive contact pad on a surface of one printed circuit board layer to a further conductive contact pad on a surface of another printed circuit board layer, with the printed circuit board with the non-conducting region lying between the two printed circuit board layers with pads connected by the via; and
the largest width dimension of the conductive contact pads on the surfaces of the printed circuit board layers connected by the via are less than the smallest width dimension of the non-conducting region.

2. A multilayer circuit board according to claim 1, wherein a width of a conductive track connected to one of the conductive contact pads is substantially larger than a largest width dimension of the conductive contact pads.

3. A multilayer circuit board according to claim 1 or claim 2, wherein the smallest width dimension is greater than or equal to 6 times the diameter of the via.

4. A multilayer circuit board according to claim 3, wherein the smallest width dimension is greater than or equal to 8 times the diameter of the via.

5. A multilayer circuit board according to any of claims 1 to 4, wherein the non-conducting region is substantially circular, and the smallest width dimension is the diameter of the non-conducting region.

6. A multilayer circuit board according to any of claims 2 to 5, wherein the largest width dimension of the conductive contact pads is their diameters.

7. A multilayer circuit board according to any of claims 1 to 6, wherein the conductive track is spaced from one or more conductive transmission lines on that surface, and the conductive track is substantially parallel to the one or more conductive transmission lines.

8. A multilayer circuit board according to any of claims 1 to 7, further comprising a plurality of further conductively plated vias passing through the printed circuit board layers, wherein the further conductively plated vias are for providing grounding and suppression of electromagnetic parallel plate modes.

9. A multilayer circuit board according to claim 8, wherein the further conductively plated vias are arranged in more than one parallel rows of vias.

10. A method of manufacturing a multilayer circuit board for applications at frequencies equal to or greater than 1 GHz, the method comprising:
providing a plurality of printed circuit board layers;
providing, on the surface of one of the printed circuit board layers, a conducting region surrounding a non-conducting region;
stacking together the plurality of printed circuit board layers; and
forming a conductively plated via passing through at least the printed circuit board layer with the non-conducting region, the via being formed such that the non-conducting region is substantially centred around a point on the surface of the printed circuit board layer where the via intersects the surface; wherein
the non-conducting region is provided such that a smallest width dimension, that includes the point on the surface, of the non-conducting region is greater than or equal to 4 times the diameter of the via;
the via electrically connects a conductive contact pad on a surface of one printed circuit board layer to a further conductive contact pad on a surface of another printed circuit board layer, with the printed circuit board with the non-conducting region lying between the two printed circuit board layers with pads connected by the via; and
the largest width dimension of the conductive contact pads on the surfaces of the printed circuit board layers connected by the via are less than the smallest width dimension of the non-conducting region.
